# FASCICULE DE BREVET EUROPEEN

(11) **EP 2 622 605 B1**
(45) Date de publication et mention de la délivrance du brevet: **23.03.2016**
(21) Numéro de dépôt: 11779760.5
(22) Date de dépôt: 29.09.2011
(51) Int. Cl.: G11C 11/16, H01L 43/08

(54) **DISPOSITIF MAGNETIQUE A ECRITURE ASSISTEE THERMIQUEMENT**
MAGNETVORRICHTUNG MIT WÄRMEUNTERSTÜTZTEM SCHREIBVORGANG
MAGNETIC DEVICE HAVING HEAT-ASSISTED WRITING

(30) Priorité: 01.10.2010 FR 1057985
(43) Date de publication de la demande: 07.08.2013
(73) Titulaire: Commissariat à l'Énergie Atomique et aux Énergies Alternatives, 75015 Paris (FR)
(72) Inventeur: DIENY, Bernard, F-38250 Lans En Vercors (FR); MORITZ, Jérôme, 38870 Saint-Pierre-de-Bressieux (FR); SOUSA, Ricardo, 38000 Grenoble (FR)
(74) Mandataire: Lebkiri, Alexandre
(86) Numéro de dépôt international: PCT/FR2011/052275
(87) Numéro de publication internationale: WO 2012/042178

(56) Documents cités:
- WO-A1-2009/074411
- US-A1- 2006 098 354
- US-A1- 2007 096 229
- US-A1- 2010 090 300
- US-A1- 2010 110 783

## Description

La présente invention concerne un dispositif magnétique à écriture assistée thermiquement.

L'invention trouve une application en électronique et notamment dans la réalisation de points mémoire et de mémoire de type MRAM (« Magnetic Random Access Memory » ou mémoire magnétique à accès direct).

Les mémoires magnétiques MRAM ont connu un regain d'intérêt avec la mise au point de jonction tunnel magnétique présentant une forte magnétorésistance à température ambiante. Les mémoires MRAM comportent plusieurs points mémoires. Ces points mémoires sont généralement des dispositifs magnétiques qui comportent :
- une couche magnétique appelée « couche de référence » qui présente une aimantation dont la direction est fixe ;
- une couche magnétique appelée « couche de stockage » qui présente une aimantation dont la direction est variable et qui peut s'orienter soit parallèlement, soit antiparallèlement à la direction d'aimantation de la couche de référence ;
- un espaceur réalisé dans un matériau isolant ou semi-conducteur qui sépare la couche de référence et la couche de stockage.

Le document FR2817999 décrit par exemple un tel dispositif magnétique. Ce dispositif magnétique présente deux modes de fonctionnement : un mode « lecture » et un mode « écriture ». Lors du mode écriture, un courant d'électrons ou un champ magnétique est envoyé à travers les couches, de façon à provoquer le retournement de la direction d'aimantation de la couche de stockage, qui devient alors parallèle ou antiparallèle à la direction d'aimantation de la couche de référence. Suivant que la direction d'aimantation de la couche de stockage est parallèle ou antiparallèle à la direction d'aimantation de la couche de référence, un « 1 » ou un « 0 » est stocké dans la couche de stockage.

Lors du mode lecture, un courant d'électrons est injecté à travers le dispositif magnétique de façon à lire sa résistance. Lorsque les directions d'aimantation de la couche de référence et de la couche de stockage sont parallèles, la résistance de la jonction est faible, tandis que lorsque les directions d'aimantation des couches de référence et de stockage sont antiparallèles, la résistance de la jonction est élevée. Par comparaison avec une résistance de référence, la valeur stockée dans la couche de stockage (« 0 » ou « 1 ») peut être déterminée.

Le document FR2924851 propose par ailleurs d'ajouter au dispositif décrit précédemment une couche antiferromagnétique au contact de la couche de stockage. En mode lecture, cette couche antiferromagnétique permet de figer la direction d'aimantation de la couche de stockage afin que l'information stockée dans la couche de stockage ne varie pas. En mode écriture par contre, la couche antiferromagnétique est chauffée de façon à ce qu'elle devienne paramagnétique ou tout au moins que sa température excède la température dite de blocage de la couche antiferromagnétique. Cette température de blocage est en générale inférieure à la température de Néel du matériau antiferromagnétique mais elle se rapproche de plus en plus de la température de Néel au fur et à mesure que la durée du chauffage diminue vers des durées de l'ordre de quelques nanosecondes. La température de Néel du matériau antiferromagnétique est la température à laquelle l'ordre antiferromagnétique disparait et au dessus de laquelle le matériau se comporte comme un paramagnétique. Lorsque la température de la couche antiferromagnétique dépasse la température de blocage, la direction d'aimantation de la couche de stockage peut alors être modifiée puisqu'elle n'est plus piégée par la couche antiferromagnétique. Une fois que l'on a modifié la direction d'aimantation de la couche de stockage, le chauffage de la couche antiferromagnétique est arrêté. La couche antiferromagnétique redevient alors antiferromagnétique. La direction d'aimantation de la couche de stockage est alors piégée dans la direction dans laquelle elle se trouvait à l'issue du processus d'écriture. Les dispositifs magnétiques qui comportent une telle couche antiferromagnétique et mettent en oeuvre un chauffage temporaire de cette couche au moment de l'écriture de l'information font partie des dispositifs dits « à écriture assistée thermiquement ».

Les dispositifs magnétiques à écriture assistée thermiquement sont avantageux car ils permettent de diminuer le risque d'écriture accidentelle lors de la lecture de l'information contenue dans la couche de stockage. Par ailleurs, ils possèdent une bien meilleure rétention que les dispositifs ne mettant pas en oeuvre l'assistance thermique, c'est-à-dire qu'ils ont une meilleure capacité à conserver l'information écrite au cours du temps.

Toutefois, dans ces dispositifs à écriture assistée thermiquement, on observe une densité importante de défauts structurels en raison de l'incompatibilité structurelle entre la couche antiferromagnétique, qui présente généralement une structure cristallographique cubique face centrée, et la couche de stockage, qui présente généralement une structure cristallographique cubique centrée lorsqu'elle est en contact avec une barrière tunnel de MgO. Ces défauts structurels ont un impact direct sur la qualité du piégeage de la couche de stockage par la couche antiferromagnétique.

Pour remédier à ces inconvénients, le document FR2924851 propose d'ajouter dans la couche de stockage une couche amorphe ou quasi-amorphe, par exemple en Tantale, ainsi qu'une couche ferromagnétique à structure cristallographique cubique face centrée, par exemple en permalloy NiFe. L'ajout de ces couches permet de réaliser une transition structurelle entre la couche antiferromagnétique et les couches qui présentent une structure cristallographique cubique centré.

Toutefois, les dispositifs magnétiques à écriture assistée thermiquement de l'art antérieur présentent de nombreux inconvénients lorsque l'on diminue leur taille latérale. Tout d'abord, lorsque l'on diminue la taille latérale des dispositifs magnétiques de l'art antérieur, la coercitivité de la couche de stockage augmente, de sorte que l'écriture de la couche de stockage devient plus difficile.

En outre, lorsque l'on diminue la taille des dispositifs à écriture assistée thermiquement de l'art antérieur, la stabilité de la couche antiferromagnétique diminue, tout comme le piégeage de la couche de stockage par la couche antiferromagnétique. En effet, la couche antiferromagnétique présente une structure granulaire polycristalline et les grains constituant la couche sont faiblement couplés magnétiquement entre eux. Or lorsque l'on diminue la taille du dispositif magnétique, on augmente la proportion de grains de la couche antiferromagnétique qui sont situés à la périphérie de la couche antiferromagnétique. De plus, ces grains en périphérie sont en partie rognés par le processus de gravure, ce qui a pour effet de rendre leur aimantation moins stable. On peut même les qualifier de magnétiquement instables lorsque la partie rognée dépasse un certain pourcentage de la surface initiale du grain. À mesure que la taille du dispositif diminue, la distribution de taille des grains constituant la couche antiferromagnétique tend à s'élargir. Il en résulte des fluctuations de propriétés de piégeage très importantes d'un dispositif à l'autre, et dans l'exemple des mémoires magnétiques d'un point mémoire à l'autre. Ainsi, lorsqu'on grave les dispositifs de l'art antérieur de faibles dimensions, le volume de ces grains périphériques diminue, ce qui entraîne une diminution de la cohérence magnétique de la couche antiferromagnétique. Cette diminution de la cohérence magnétique de la couche antiferromagnétique entraîne une diminution plus ou moins forte de la qualité de piégeage de la couche de stockage par la couche antiferromagnétique et une augmentation de la dispersion des propriétés de piégeage d'un point à l'autre.

L'invention vise à remédier, au moins partiellement, aux inconvénients de l'état de la technique en proposant un dispositif magnétique à écriture assistée thermiquement dont la taille peut être diminuée sans que la stabilité de la couche antiferromagnétique, et donc la stabilité de la couche de stockage en lecture, ne diminue.

Un autre objet de l'invention est de proposer un dispositif magnétique à écriture assistée thermiquement dans lequel l'écriture de la couche de stockage est facilitée.

Un autre objet de l'invention est de proposer un dispositif magnétique dans lequel la lecture de l'information contenue dans la couche de stockage est facilitée.

Pour ce faire, l'invention propose un dispositif magnétique à écriture assistée thermiquement comportant :
- une première couche magnétique dite « couche de référence »,
- une deuxième couche magnétique dite « couche de stockage », la couche de stockage présentant une direction d'aimantation variable,
- un espaceur situé entre la couche de référence et la couche de stockage,
- une première couche antiferromagnétique au contact de la couche de stockage, la première couche antiferromagnétique étant apte à piéger la direction d'aimantation de la couche de stockage ;
le dispositif magnétique étant caractérisé en ce qu'il comporte en outre une couche de stabilisation réalisée dans un matériau ferromagnétique, la couche de stabilisation étant au contact de la première couche antiferromagnétique par sa face opposée à la couche de stockage.

Ainsi, selon l'invention, on augmente la cohésion magnétique de la première couche antiferromagnétique en augmentant le couplage effectif entre les grains constitutifs de la couche antiferromagnétique. Pour cela, l'invention propose d'ajouter une couche de stabilisation en matériau ferromagnétique au contact de la première couche antiferromagnétique. La présence de cette couche de stabilisation en matériau ferromagnétique permet de renforcer le couplage de grains à grains à l'intérieur de la première couche antiferromagnétique. En effet, lorsque la première couche en matériau antiferromagnétique est seule, les grains qui la constituent sont très faiblement couplés entre eux. Au contraire, dans une couche en matériau ferromagnétique, les grains sont très fortement couplés entre eux. Lorsque l'on met en contact une couche ferromagnétique et une couche antiferromagnétique, l'aimantation des grains de la couche ferromagnétique a tendance à s'aligner avec le dernier plan de spins interfaciaux des grains de la couche en matériau antiferromagnétique. Il en résulte que chaque grain de la couche ferromagnétique est fortement couplé magnétiquement avec le grain de la couche antiferromagnétique avec lequel il est en contact. En outre, les grains de la couche de stabilisation en matériau ferromagnétique sont très fortement couplés entre eux, de sorte que les grains de la première couche antiferromagnétique deviennent également couplés entre eux, par l'intermédiaire des grains de la couche ferromagnétique. La couche de stabilisation permet donc d'augmenter la cohésion magnétique de la première couche antiferromagnétique en induisant de façon indirecte un couplage entre grains à l'intérieur de la couche antiferromagnétique. Ainsi dans un dispositif de dimension latérale fortement submicronique, les grains situés à la périphérie du dispositif qui étaient initialement instables, se trouvent stabilisés par ce couplage indirect intergrains. Il en résulte que cette couche de stabilisation permet d'augmenter le couplage d'échange entre la première couche antiferromagnétique et la couche de stockage. Ainsi hors événement d'écriture, c'est-à-dire tant que la couche antiferromagnétique n'est pas chauffée au dessus de sa température de blocage, le piégeage de la couche de stockage par la couche antiferromagnétique adjacente reste efficace même pour des dispositifs de dimension latérale fortement submicronique.

Le dispositif magnétique selon l'invention peut également présenter une ou plusieurs des caractéristiques ci-dessous, considérées individuellement ou selon toutes les combinaisons techniquement possibles.

Dans ce document, on appelle « moment magnétique » d'une couche magnétique, le produit de l'aimantation de cette couche magnétique par l'épaisseur de cette couche magnétique.

Avantageusement, la couche de stabilisation présente un moment magnétique supérieur au moment magnétique de la couche de stockage.

Pour cela, la couche de stabilisation présente de préférence une épaisseur supérieure à l'épaisseur de la couche de stockage.

Dans ce cas, la couche de stabilisation permet l'écriture de la couche de stockage grâce à un champ magnétique. Ce champ magnétique peut par exemple être créé par un conducteur traversé par un courant comme c'est le cas dans les mémoires magnétiques MRAM à écriture par champ magnétique. Lorsque l'on applique un pulse de champ magnétique au dispositif magnétique, ce champ magnétique permet d'orienter en premier lieu la direction d'aimantation de la couche de stabilisation, puisque c'est elle qui présente le plus fort moment magnétique. La couche de stabilisation rayonne alors un champ magnétique de fuite par les bords du dispositif qui tend à aligner la direction d'aimantation de la couche de stockage antiparallèlement par rapport à la direction d'aimantation de la couche de stabilisation. La couche de stabilisation agit donc comme un « levier » qui permet de créer un champ magnétique de fuite qui est supérieur au champ magnétique initial de façon à provoquer le retournement de la direction d'aimantation de la couche de stockage.

Avantageusement, la couche de stabilisation présente une épaisseur comprise entre 5 et 20 nm.

Avantageusement, la couche de stockage présente une épaisseur comprise entre 1 nm et 4 nm.

Ainsi, si les couches de stabilisation et de stockage sont constituées de matériaux d'aimantations identiques ou voisines, la couche de stabilisation présente un moment magnétique sensiblement plus important que la couche de stockage et elle peut donc agir comme un amplificateur du champ magnétique appliqué à la couche de stockage. Si les aimantations des couches de stabilisation et de stockage sont différentes, le raisonnement ci-dessus s'applique sur les moments magnétiques et non pas directement sur les épaisseurs des couches de stabilisation et de stockage.

Avantageusement, la couche de stabilisation présente une direction d'aimantation variable, le dispositif magnétique comportant en outre des moyens d'émission d'un champ magnétique aptes à modifier la direction d'aimantation de la couche de stabilisation. En effet, dans le dispositif magnétique selon l'invention, il est particulièrement avantageux de modifier la direction d'aimantation de la couche de stockage par champ magnétique par l'intermédiaire de la couche de stabilisation.

Selon un mode de réalisation, les moyens d'émission d'un champ magnétique peuvent comporter un conducteur dans lequel passe un courant électrique. Ce conducteur peut être enrobé sur certaines de ses faces d'un matériau magnétique doux permettant d'augmenter le champ créé au niveau de la couche de stabilisation. Cette technologie est connue sous le vocable de « cladding » dans le contexte des mémoires magnétiques MRAM écrite par champ magnétique.

Avantageusement, le dispositif magnétique selon l'invention présente une section elliptique suivant le plan des couches ou plus généralement présente une anisotropie de forme dans son plan conduisant à une direction facile d'aimantation dans le plan des couches suivant la plus grande dimension des couches magnétiques considérées du dispositif magnétique. En particulier, la couche de stabilisation présente de préférence une section elliptique. Le fait d'avoir une couche de stabilisation de section elliptique ou tout au moins présentant une anisotropie de forme planaire, permet d'éviter que la couche de stabilisation ne se mette en état vortex.

Selon un premier mode de réalisation, la couche de référence présente une direction d'aimantation piégée par une deuxième couche antiferromagnétique disposée au contact de la couche de référence.

Dans ce cas, la deuxième couche antiferromagnétique doit présenter une température de Néel supérieure à la température de Néel de la première couche antiferromagnétique.

Dans ce document, on appelle « température de Néel » la température au-dessus de laquelle un matériau antiferromagnétique devient paramagnétique.

Le fait d'avoir une température de Néel pour la deuxième couche antiferromagnétique supérieure à la température de Néel de la première couche antiferromagnétique permet de chauffer la première couche antiferromagnétique de façon à pouvoir modifier la direction d'aimantation de la couche de stockage, tout en restant à une température inférieure à la température de Néel de la deuxième couche antiferromagnétique, de façon à ce que la direction d'aimantation de la couche de référence reste bloquée par la deuxième couche antiferromagnétique.

En mode lecture, on injecte un courant dans le dispositif magnétique et on mesure la résistance du dispositif magnétique. On compare ensuite cette valeur avec une valeur de référence standard. Si la résistance du dispositif magnétique est inférieure à la valeur de référence standard, on en déduit que les couches de référence et de stockage présentent des directions d'aimantation parallèles. Au contraire, si la résistance mesurée pour le dispositif est supérieure à la valeur de référence standard, on en déduit que les couches de référence et de stockage présentent des directions d'aimantation antiparallèles. La direction d'aimantation de la couche de référence étant figée, il est alors facile d'en déduire la direction d'aimantation de la couche de stockage et donc la valeur contenue dans la couche de stockage.

Selon un deuxième mode de réalisation, la couche de référence présente une direction d'aimantation variable. Le fait d'avoir une couche de référence dont la direction d'aimantation est variable est possible, puisque, selon l'invention, la couche de référence n'est pas nécessaire pour modifier la direction d'aimantation de la couche de stockage. En effet, comme expliqué précédemment, selon l'invention, la direction d'aimantation de la couche de stockage est modifiée par application d'un pulse de champ magnétique qui soit agit directement sur l'aimantation de la couche de stockage, soit agit sur l'aimantation de la couche de stabilisation qui à son tour, par son champ rayonné sur la couche de stockage agit sur l'aimantation de la couche de stockage. En conséquence, l'orientation de l'aimantation de la couche de référence au moment de l'écriture à peu d'importance sur le processus d'écriture. La couche de référence peut donc présenter une direction d'aimantation variable, ce qui présente de nombreux avantages. Tout d'abord, le choix du matériau antiferromagnétique pour réaliser la première couche antiferromagnétique n'est pas limité par la température de Néel de la deuxième couche antiferromagnétique. En outre, le fait d'avoir une couche de référence dont la direction d'aimantation est variable est particulièrement avantageux en mode lecture. En effet, dans ce cas, il est possible de réaliser une lecture différentielle de l'information contenue dans la couche de stockage à l'aide de la couche de référence. Pour cela, on compare la résistance du dispositif magnétique pour deux orientations différentes de la direction d'aimantation de la couche de référence. Pour cela, on oriente, avec un premier pulse de champ magnétique, la direction d'aimantation de la couche de référence dans un sens prédéterminé. Cette modification de la direction d'aimantation de la couche de référence a lieu sans chauffage, c'est-à-dire avec un courant de lecture traversant la jonction tunnel suffisamment faible pour chauffer très peu, c'est-à-dire bien en dessous de sa température de Néel, la jonction et donc ne pas modifier la direction de l'aimantation de la couche de stockage. On mesure alors la résistance du dispositif magnétique. On applique ensuite un deuxième pulse de champ magnétique au dispositif, toujours sans chauffer, de façon à orienter la direction d'aimantation de la couche de référence dans le sens opposé au premier sens prédéterminé. On mesure alors à nouveau la résistance du dispositif magnétique. Après chaque pulse de courant, on connaît la direction d'aimantation de la couche de référence, puisqu'on connaît la direction des pulses de champs magnétiques appliqués. Par conséquent, en comparant la résistance du dispositif magnétique après le premier pulse de courant et après le deuxième pulse de courant, on en déduit la direction d'aimantation de la couche de stockage. Ce mode de lecture du dispositif magnétique est particulièrement avantageux car il permet une lecture plus précise de l'information contenue dans la couche de stockage. En effet, les valeurs des résistances lorsque les couches de référence et de stockage sont parallèles ou antiparallèles peuvent varier d'un dispositif magnétique à l'autre. Par conséquent, lorsque l'on compare la résistance d'un dispositif magnétique à une valeur de référence standard, le résultat de la comparaison n'est parfois pas représentatif de l'état réel du dispositif magnétique du fait des différences entre ce dispositif magnétique et le dispositif magnétique qui a permis d'établir la valeur de référence standard. Au contraire, avec ce deuxième mode de réalisation, on n'utilise plus de valeur de référence standard, mais on place un même dispositif magnétique dans deux états et on compare ces deux états entre eux, ce qui permet d'avoir des résultats moins sensibles aux fluctuations de résistance de dispositif à dispositif. Ceci permet de tolérer davantage de dispersion dans les résistances et amplitudes de magnétorésistance de dispositif à dispositif et ainsi de rendre le procédé de fabrication moins difficile, en particulier dans le contexte de fabrication de puce MRAM de forte densité. Par contre, ce deuxième mode de réalisation rend la lecture plus lente que le premier mode de réalisation puisque cette lecture auto-différentielle met en fait en oeuvre deux écritures, deux lectures et une comparaison des deux lectures.

Pour améliorer la vitesse de lecture du dispositif magnétique selon ce deuxième mode de réalisation, on peut lire l'information contenue dans la couche de stockage de manière dynamique. Pour cela, on envoie un pulse de courant à travers le dispositif magnétique, ce pulse de courant effectuant une oscillation, ce qui créé un pulse de tension aux bornes du dispositif. Le pulse de tension ainsi créé peut présenter un pic de tension qui est soit positif, soit négatif, suivant que les aimantations des couches de stockage et de référence sont parallèles ou antiparallèles. Le signe de ce pic de tension permet donc de connaître la direction d'aimantation de la couche de stockage plus rapidement.

Selon différents modes de réalisation, la couche de stockage peut être constituée d'une monocouche magnétique ou alors elle peut être constituée d'un empilement de couches.

Selon un mode de réalisation, la couche de stockage comporte au moins un empilement formé par:
- une couche de transition constituée d'un matériau ferromagnétique présentant une structure cristallographie cubique face centrée au contact de la première couche antiferromagnétique ;
- une couche amorphe ou quasi-amorphe au contact de la couche de transition ;
- une couche ferromagnétique de stockage.

Ainsi, il existe une transition structurelle entre la première couche antiferromagnétique qui est cubique face centrée, et les couches qui présentent une structure cristallographique cubique centrée.

Selon un autre mode de réalisation, la couche de stockage est constituée d'un empilement tricouche antiferromagnétique synthétique comportant une première et une deuxième couches magnétiques séparées par une couche conductrice non magnétique apte à induire un couplage antiparallèle entre les aimantations des couches magnétiques qui lui sont adjacentes.

Avantageusement, l'empilement tricouche antiferromagnétique synthétique présente un moment magnétique résultant non nul. En effet, pour que le champ magnétique de fuite issu de la couche de stabilisation puisse avoir un effet sur la couche de stockage, la couche de stockage doit présenter un moment magnétique résultant non nul. Pour cela, les deux couches magnétiques de l'empilement tricouche antiferromagnétique synthétique ne doivent pas présenter des moments magnétiques qui se compensent parfaitement. Pour cela, les deux couches magnétiques de l'empilement tricouche antiferromagnétique synthétique peuvent par exemple présenter des épaisseurs différentes. Toutefois, dans ce raisonnement, il faut bien tenir compte du fait que la couche magnétique de l'empilement tricouche antiferromagnétique synthétique en contact avec la couche antiferromagnétique est plus proche de la couche de stabilisation que ne l'est l'autre couche magnétique de cette tricouche. En conséquence, le champ de fuite rayonné par l'aimantation de la couche de stabilisation sur la couche en contact avec l'antiferromagnétique est légèrement plus grand que celui rayonné sur l'autre couche magnétique constitutive du tricouche.

En appelant « première couche magnétique », la couche magnétique de l'empilement tricouche antiferromagnétique synthétique qui est au contact de l'espaceur, et « deuxième couche magnétique » celle de l'empilement antiferromagnétique synthétique qui est au contact de la première couche antiferromagnétique, alors avantageusement la première couche magnétique de l'empilement tricouche antiferromagnétique synthétique présente un moment magnétique supérieur au moment magnétique de la deuxième couche magnétique de l'empilement tricouche antiferromagnétique synthétique. Ainsi, le champ magnétique de fuite créé par la couche de stabilisation lorsqu'elle est soumise à un champ magnétique extérieure oriente la direction d'aimantation de la première couche magnétique antiparallèlement à la direction d'aimantation de la couche de stabilisation. Ceci a pour effet d'orienter l'aimantation de la deuxième couche magnétique parallèlement à celle de la couche de stabilisation.

Selon un mode de réalisation, la couche de référence est constituée d'un empilement tricouche antiferromagnétique synthétique comportant deux couches magnétiques séparées par une couche conductrice non magnétique apte à induire un couplage antiparallèle entre les aimantations des couches magnétiques adjacentes.

L'invention concerne également une mémoire magnétique à écriture assistée thermiquement dont chaque point mémoire est constitué d'un dispositif magnétique selon l'invention.

D'autres caractéristiques et avantages de l'invention ressortiront à la lecture de la description qui suit, en référence aux figures annexées, qui illustrent :
- la figure 1, une vue en coupe d'un dispositif magnétique selon un premier mode de réalisation de l'invention ;
- la figure 2, une vue de dessus du dispositif magnétique de la figure 1 ;
- la figure 3, une vue en coupe schématique de l'interface entre la première couche antiferromagnétique du dispositif de la figure 1 et la couche de stabilisation d'une part et la couche de stockage d'autre part ;
- la figure 4, une vue en coupe d'un dispositif magnétique selon un autre mode de réalisation de l'invention ;
- la figure 5, une vue en coupe du dispositif de la figure 4 lors de l'écriture d'une information dans la couche de stockage ;
- la figure 6, une vue en coupe d'un dispositif magnétique selon un autre mode de réalisation de l'invention ;
- la figure 7, une vue en coupe d'un dispositif magnétique selon un autre mode de réalisation de l'invention.

Pour plus de clarté, les éléments identiques ou similaires sont repérés par des signes de référence identiques sur l'ensemble des figures.

Sur l'ensemble des figures, les flèches qui portent la référence « D » représentent la direction d'aimantation de la couche sur laquelle elles sont situées. Les flèches notées « I » représentent des courants d'électrons.

Dans l'ensemble des modes de réalisation décrits en référence aux figures, les couches magnétiques présentent une direction d'aimantation dans le plan, c'est-à-dire que les aimantations des couches magnétiques sont parallèles ou antiparallèles au plan dans lequel chaque couche se trouve. Toutefois, on pourrait également réaliser le dispositif magnétique selon l'invention avec des aimantations hors du plan, c'est-à-dire que les aimantations des couches magnétiques seraient perpendiculaires au plan dans lequel se trouvent les couches magnétiques.

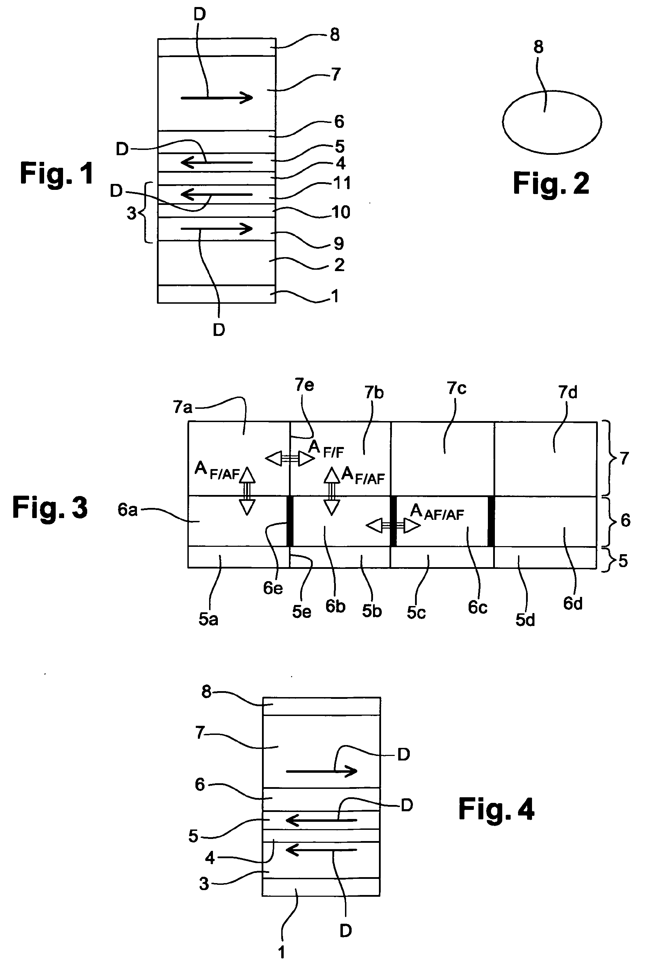

Les figures 1 et 2 représentent un dispositif magnétique selon un mode de réalisation de l'invention. Ce dispositif magnétique comporte une couche tampon 1 qui sert de base à la croissance des autres couches du dispositif magnétique. Cette couche tampon 1 est de préférence réalisée dans un matériau non-magnétique. Elle peut par exemple être réalisée dans un alliage nickel-fer-chrome contenant au moins 20% de Cr, ou en nitrure de cuivre ou avoir une structure de multicouche constituée d'une alternance de couches de cuivre, et de couches de tantale. Bien entendu, ces matériaux ne sont donnés qu'à titre illustratif, sans restreindre l'invention.

Le dispositif magnétique comporte également une couche de couverture 8 qui protège l'empilement de couches du dispositif magnétique de l'oxydation ou permet le cas échéant d'assurer la connexion électrique de l'empilement avec l'électrode supérieure de l'empilement. Cette couche de couverture 8 peut par exemple être constituée de tantale, de nitrure de cuivre ou avoir une structure de multicouche constituée d'une alternance de couches de cuivre et de couches de tantale.

Entre la couche tampon 1 et la couche de couverture 8, le dispositif magnétique comporte ensuite une deuxième couche antiferromagnétique 2 qui est disposée contre la couche tampon 1. Cette deuxième couche antiferromagnétique 2 peut être par exemple en PtMn d'épaisseur comprise entre 12 et 30 nm ou en NiMn d'épaisseur entre 20nm et 50nm. La deuxième couche antiferromagnétique 2 est de préférence réalisée dans un matériau antiferromagnétique qui présente une température de Néel élevée, typiquement supérieure ou égale à 350°C. Les matériaux cités ci-dessus pour la couche antiferromagnétique 2 ne sont donnés qu'à titre illustratif et d'autres matériaux pourraient être utilisés sans sortir du cadre de l'invention.

Le dispositif magnétique comporte ensuite une couche de référence 3 au contact de la deuxième couche antiferromagnétique 2. La couche de référence 3 peut être une monocouche, ou alors elle peut être constituée d'un empilement de couches, et notamment elle peut être constituée d'un empilement tricouche antiferromagnétique synthétique comme représenté sur la figure 1. L'empilement tricouche antiferromagnétique synthétique représenté sur la figure 1 est constitué de deux couches magnétiques 9 et 11 séparées par une couche conductrice non magnétique 10 apte à induire un alignement antiparallèle entre les aimantations des couches magnétiques adjacentes. La couche magnétique 9 peut par exemple être constituée d'un alliage cobalt-fer, tandis que la couche magnétique 11 peut être constituée d'un alliage cobalt-fer-bore, ou inversement. On peut également réaliser les deux couches magnétiques 9 et 11 dans le même alliage magnétique. Chaque couche magnétique 9 et 11 présente de préférence une épaisseur comprise entre 1 et 4 nm. Les deux couches magnétiques 9 et 11 présentent de préférence des épaisseurs voisines, de façon à ce que le champ rayonné par l'ensemble des deux couches magnétiques 9 et 11 au niveau de la couche de stockage 5 soit le plus faible possible. La couche conductrice non magnétique 10 peut par exemple être réalisée en ruthénium d'épaisseur entre 0.5 nm et 0.9nm, épaisseurs pour lesquelles il est connu que le ruthénium induit un couplage antiparallèle entre aimantations des couches magnétiques adjacentes. Les deux couches magnétiques 9 et 11 sont couplées antiparallèlement à travers la couche conductrice non magnétique 10. La direction d'aimantation des deux couches magnétiques 9 et 11 est figée par la deuxième couche antiferromagnétique 2, tant que le dispositif magnétique est à une température inférieure à la température de Néel du matériau antiferromagnétique qui constitue la deuxième couche antiferromagnétique 2. Les matériaux constitutifs de la couche de référence sont bien connus de l'homme du métier et ne sont donnés ici qu'à titre indicatif, sans pour autant restreindre l'invention.

Le dispositif magnétique comporte ensuite une couche de stockage 5 séparée de la couche de référence 3 par un espaceur 4. L'espaceur 4 peut être une barrière tunnel sélectionnée dans un groupe comprenant les oxydes d'aluminium AlOₓ, de titane TiOₓ et l'oxyde de magnésium MgO. Alternativement, l'espaceur 4 peut être constitué d'un semiconducteur. Ainsi, l'espaceur peut être constitué de silicium, de germanium ou de GaAs. On peut également réaliser l'espaceur 4 dans une couche métal/oxyde hétérogène comme une couche à chemins de courant confiné constituée d'une barrière isolante par exemple en Alumine d'épaisseur 2 nm percée de canaux conducteurs qui sont par exemple en cuivre de diamètre nanométrique, typiquement entre 1 et 4nm. L'espaceur 4 présente de préférence une épaisseur comprise entre 0.6nm et 5 nm.

La couche de stockage 5 est une couche magnétique qui présente une direction d'aimantation variable. Cette couche de stockage 5 peut être une monocouche magnétique ou un empilement de couches. La couche de stockage 5 peut par exemple être constituée d'un empilement de couches comportant :
- une couche de transition constituée d'un matériau ferromagnétique présentant une structure cristallographie cubique face centrée au contact de la première couche antiferromagnétique ;
- une couche amorphe ou quasi-amorphe au contact de la couche de transition ;
- une couche ferromagnétique de structure cristallographique cubique centrée.

Ce type de couche de stockage est particulièrement intéressant dans le cas où l'espaceur 4 est une barrière tunnel à base de MgO dont la structure cristallographique est cubique centrée.

La couche de stockage 5 peut également être constituée d'un empilement tricouche antiferromagnétique synthétique.

Dans l'exemple de la figure 1, la couche de stockage 5 est constituée d'une monocouche. Cette monocouche peut par exemple être constituée d'un alliage cobalt-fer-bore. La couche de stockage présente de préférence une épaisseur comprise entre 1 et 4 nm.

Bien entendu les caractéristiques de la couche de stockage ne sont données ici qu'à titre indicatif, et l'homme du métier saurait adapter l'invention à d'autres types de couches de stockage.

Le dispositif magnétique comporte ensuite, au contact de la couche de stockage 5, une première couche antiferromagnétique synthétique 6 qui permet de piéger la direction d'aimantation de la couche de stockage 5 lors de la lecture, et qui permet la libération de la direction d'aimantation de la couche de stockage 5 lors de l'écriture. La première couche antiferromagnétique 6 peut par exemple être en IrMn d'épaisseur comprise entre 5 et 7 nm ou en FeMn d'épaisseur typiquement entre 7 et 12nm. La première couche antiferromagnétique 6 présente de préférence une température de Néel suffisamment élevée pour qu'en l'absence de chauffage, la première couche antiferromagnétique 6 piège la direction d'aimantation de la couche de stockage 5. Toutefois, cette température de Néel ne doit pas être trop élevée pour qu'il ne soit pas trop difficile de libérer la direction d'aimantation de la couche de stockage 5, mais aussi pour pouvoir libérer la direction d'aimantation de la couche de stockage 5 sans libérer la direction d'aimantation de la couche de référence 3. Ainsi, la première couche antiferromagnétique 6 présente de préférence une température de Néel comprise entre 200 et 300°C. La première couche antiferromagnétique 6 peut par exemple être réalisée en alliage iridium-manganèse, fer-manganèse ou en alliage iridium-manganèse-chrome avec un pourcentage massique de chrome compris entre 10 et 25%.

Le dispositif magnétique comporte en outre, au contact de la première couche antiferromagnétique 6, une couche de stabilisation 7 réalisée dans un matériau ferromagnétique. Cette couche de stabilisation 7 peut par exemple être réalisée dans un alliage cobalt-fer, NiFe ou CoFeB.

Le dispositif magnétique présente de préférence une section elliptique, comme on peut le voir plus précisément sur la figure 2, ou tout au moins une anisotropie de forme dans son plan afin de diminuer au maximum le risque que la couche de stabilisation 7 ne se mette en vortex.

La couche de stabilisation 7 permet de renforcer la cohérence magnétique de la première couche antiferromagnétique 6, et, elle permet d'augmenter le piégeage de la direction d'aimantation de la couche de stockage 5 par la première couche antiferromagnétique 6.

Ce phénomène va être expliqué plus en détail en référence à la figure 3 qui représente schématiquement, au niveau microscopique, la couche de stockage 5, la première couche antiferromagnétique 6 et la couche de stabilisation 7. Chacune de ces couches est constituée de grains, respectivement 5a à 5d, 6a à 6d et 7a à 7d. Chaque grain 5a à 5d, 6a à 6d, 7a à 7d est un domaine monocristallin qui présente sensiblement la même orientation cristallographique. Au sein d'une même couche, par exemple au sein de la première couche antiferromagnétique 6, deux grains adjacents, par exemple 6a et 6b, sont séparés par un joint de grain 6e. Chaque joint de grain 6e est donc une zone dans laquelle on passe d'une orientation cristallographique à une autre orientation cristallographique.

En l'absence de couche de stabilisation, deux grains adjacents de la première couche antiferromagnétique 6 sont très faiblement couplés magnétiquement, ce qui fait que la cohérence magnétique de la première couche antiferromagnétique 6 est faible. En d'autres termes, l'énergie de couplage A_{AF/AF} entre deux grains de la première couche antiferromagnétique en l'absence de la couche de stabilisation est très faible, par exemple de l'ordre de 10⁻³ erg/cm².

Dans ce document, on appelle « énergie de couplage » entre deux joints de grains l'énergie de couplage par unité de surface. Cette énergie s'exprime en erg/cm².

Au sein de la couche de stabilisation 7, qui est ferromagnétique, les grains sont très fortement couplés. Ainsi, l'énergie de couplage A_{F/F} entre deux grains adjacents de la couche de stabilisation est environ 10⁴ à 10⁵ fois plus forte que l'énergie de couplage A_{AF/AF} entre deux grains de la première couche antiferromagnétique en l'absence de la couche de stabilisation. En effet, l'énergie de couplage A_{F/F} entre deux grains adjacents de la couche de stabilisation est de l'ordre de grandeur de 10 erg/cm², tandis que l'énergie de couplage A_{AF/AF} entre deux grains de la première couche antiferromagnétique en l'absence de la couche de stabilisation est de l'ordre de grandeur de 10⁻³ erg/cm².

Ainsi, pour augmenter le couplage entre les grains de la première couche antiferromagnétique 6, l'invention propose d'ajouter une couche de stabilisation ferromagnétique 7 sur la première couche antiferromagnétique 6.

Comme on peut le voir schématiquement sur la figure 3, lorsque l'on dépose la couche de stabilisation 7 sur la première couche antiferromagnétique 6, les grains 7a, 7b, 7c, 7d de la couche de stabilisation 7 s'alignent avec les grains 6a, 6b, 6c, 6d de la première couche antiferromagnétique 6. Cette croissance dite colonnaire est caractéristique de ce type d'empilements dont le dépôt est souvent réalisé par pulvérisation cathodique. Chaque grain de la couche de stabilisation, par exemple 7a, est magnétiquement couplé avec le grain 6a de la première couche antiferromagnétique 6 au dessus duquel il se trouve. Ainsi, l'énergie de couplage A_{AF/F} entre un grain de la couche de stabilisation et le grain de la première couche antiferromagnétique au dessus duquel il se trouve est de l'ordre de grandeur de 10⁻¹ à quelques 10⁻¹ erg/cm².

Par conséquent, les grains de la première couche antiferromagnétique 6 sont couplés entre eux par l'intermédiaire du couplage interfacial entre les grains de la couche de stabilisation et la première couche antiferromagnétique et du couplage inter-grains entre les grains de la couche de stabilisation.

La présence de la couche de stabilisation ferromagnétique permet donc l'existence d'un couplage effectif entre les grains de la première couche antiferromagnétique. Ce couplage permet de faire en sorte que des grains de la première couche antiferromagnétique qui serait magnétiquement instables sans la couche de stabilisation, deviennent magnétiquement stables en présence de la couche de stabilisation du fait de l'apparition du couplage inter-grains induit par la couche de stabilisation. Ceci concerne particulièrement les grains en bordure du dispositif dont la taille a pu fortement diminuer pendant le processus de gravure du dispositif.

En outre, comme on va le voir plus précisément en référence à la figure 4, la couche de stabilisation peut permettre d'écrire une information dans la couche de stockage à l'aide d'un champ magnétique plus faible que si la couche de stabilisation n'était pas présente.

L'explication est donnée en référence au dispositif magnétique de la figure 4 qui comporte une couche de référence 3 dont la direction d'aimantation n'est pas figée par une couche antiferromagnétique. Mais le principe de l'écriture serait le même si la couche de référence 3 était piégée par une deuxième couche antiferromagnétique. En référence à la figure 4, la couche de référence 4 présente une direction d'aimantation variable. Cette couche de référence 4 peut être une monocouche ou une multicouche.

Le dispositif magnétique de la figure 4 comporte également une couche de stockage 5 dont la direction d'aimantation est variable. La couche de stockage 5 peut être une monocouche ou une multicouche, mais elle doit présenter un moment magnétique résultant non nul pour être sensible au champ magnétique rayonné par la couche de stabilisation 7.

La couche de référence 3 et la couche de stockage 5 sont séparées par un espaceur 4.

Le dispositif magnétique de la figure 4 comporte également une première couche antiferromagnétique 6 au contact de la couche de stockage 5, ainsi qu'une couche de stabilisation 7 en contact avec la première couche antiferromagnétique 6.

La couche de stabilisation 7 présente un moment magnétique total plus important que la couche de stockage 5.

Pour cela, la couche de stabilisation 7 peut par exemple présenter une épaisseur supérieure à l'épaisseur de la couche de stockage. La couche de stabilisation 7 présente de préférence une épaisseur comprise entre 5 et 20 nm, par exemple égale à 7 nm, tandis que la couche de stockage présente de préférence une épaisseur comprise entre 1 et 4 nm, par exemple égale à 3 nm.

La couche de stabilisation peut par exemple en alliage cobalt-fer ou alliage nickel-fer ou nickel-fer-cobalt ou cobalt-fer-bore et la couche de stockage en alliage cobalt-fer-bore ou cobalt-fer.

En outre, le dispositif magnétique peut également comporter une couche tampon 1 et une couche de couverture 8 de part et d'autre du dispositif.

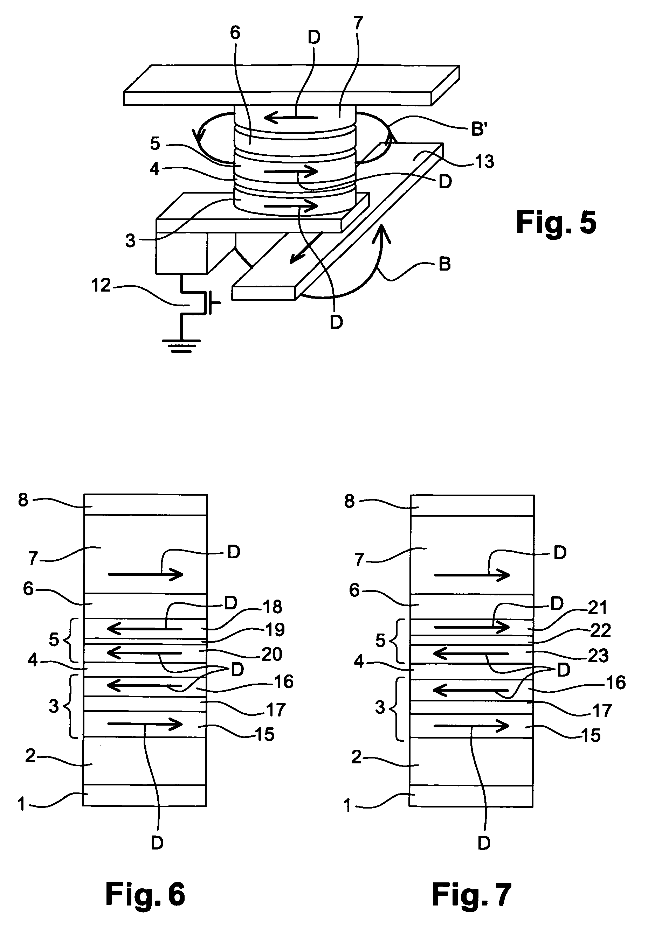

La figure 5 représente schématiquement un procédé d'écriture du dispositif de la figure 4.

Pour permettre l'écriture d'une information dans la couche de stockage, le dispositif magnétique comporte un transistor 12 qui est conducteur en mode écriture. En outre, le dispositif magnétique comporte une ligne conductrice 13 située au dessous de l'empilement magnétique. Le premier conducteur 13 est agencé de façon à ce que, lorsqu'il est traversé par un courant électrique, il créé un champ magnétique qui est parallèle ou antiparallèle à la direction d'aimantation de la couche de stabilisation. A l'écriture, le transistor 12 est en mode passant de sorte qu'un courant peut circuler à travers l'empilement provoquant un échauffement de la couche de stockage et de la première couche antiferromagnétique par effet Joule. Cet échauffement atteint une température supérieure ou égale à la température de Néel de la première couche antiferromagnétique. On notera qu'en mode écriture, il convient de chauffer la première couche antiferromagnétique à une température dite de blocage (qui peut être inférieure à la température de Néel) de sorte que la direction d'aimantation de la couche de stockage 5 ne soit plus piégée.

Pour écrire une information dans la couche de stockage, on envoie un courant à travers le conducteur 13 et à travers l'empilement, le transistor 12 étant passant. L'empilement s'échauffe alors à une température supérieure à la température de Néel de la première couche antiferromagnétique 6, de sorte que la première couche antiferromagnétique 6 devient paramagnétique et que la direction d'aimantation de la couche de stockage 5 n'est plus piégée.

Simultanément, un champ magnétique B est créé par le premier conducteur 13. Ce champ magnétique B agit sur la couche de stabilisation 7 puisqu'elle présente un fort moment magnétique du fait de son épaisseur importante. La direction d'aimantation de la couche de stabilisation 7 s'aligne alors parallèlement au champ magnétique.

La couche de stabilisation 7 rayonne alors un champ magnétique de fuite B' qui tend à aligner la direction d'aimantation de la couche de stockage 5 antiparallèlement à la direction d'aimantation de la couche de stabilisation 7.

En effet, le champ magnétique B créé par le premier conducteur 13 présente une intensité comprise entre 2 mT et 7 mT, tandis que, lorsque la couche de stabilisation 7 présente une épaisseur supérieure à 7 nm, le champ magnétique de fuite B' présente une intensité d'au moins 20 mT. Le champ magnétique de fuite B' est donc plus important que le champ magnétique B, ce qui fait que la couche de stockage ressent essentiellement ce champ magnétique de fuite B'.

Ainsi, la couche de stabilisation 7 sert d'amplificateur du champ magnétique ressenti par la couche de stockage 5 et par conséquent, elle permet de contrôler la direction d'aimantation de la couche de stockage 5 de façon plus efficace qu'en l'absence de la couche de stabilisation. Le fait d'utiliser le champ magnétique B' rayonné de la couche de stabilisation pour agir sur l'aimantation de la couche de stockage plutôt que le champ crée par la ligne de courant 13 directement permet de disposer d'un champ plus fort et ainsi de mettre l'aimantation de la couche de stockage dans une configuration micromagnétique plus proche de monodomaine, c'est-à-dire mieux saturée, qu'avec le seul champ généré par la ligne conductrice 13.

En outre, la couche de stabilisation 7 est particulièrement avantageuse car le champ magnétique de fuite B' qu'elle créé est relativement uniforme, même si le champ magnétique B initial ne l'était pas, ce qui permet d'avoir une aimantation uniforme dans la couche de stockage 5.

Une fois que la direction d'aimantation de la couche de stockage 5 a été placée dans le sens voulu, on coupe le courant qui traverse l'empilement pour permettre à l'empilement de se refroidir en présence du champ magnétique puis on coupe le courant dans le conducteur 13 pour supprimer le champ appliqué. La première couche antiferromagnétique 6 étant redevenue antiferromagnétique, elle piège la direction d'aimantation de la couche de stockage 5 dans la direction dans laquelle elle se trouve.

Il est à noter que pendant cette écriture, la couche de référence commute aussi dans la direction du champ local créé par le conducteur 13 et partiellement rayonné par les autres couches magnétiques mais ceci n'a pas d'importance puisque l'aimantation de cette couche va ensuite être réorientée dans une direction prédéterminée au moment de la lecture.

Ensuite, pour lire l'information contenue dans la couche de stockage 5, on peut effectuer une lecture différentielle grâce à la couche de référence 3. Pour cela, on compare le niveau de résistance de la jonction tunnel formée par le dispositif magnétique pour deux orientations différentes de la direction d'aimantation de la couche de référence 3. Pour cela, on oriente, avec un premier pulse de champ magnétique produit par un premier pulse de courant dans le conducteur 13, la direction d'aimantation de la couche de référence 3 dans un premier sens prédéterminé. Cette orientation de la direction d'aimantation de la couche de référence 3 a lieu sans faire circuler de courant à travers l'empilement pour ne pas le chauffer et ainsi pour ne pas modifier la direction de l'aimantation de la couche de stockage 5. On mesure alors la résistance du dispositif magnétique à l'aide d'un courant de lecture plus faible, typiquement divisé par un facteur 2, que le courant de chauffage utilisé au moment de l'écriture. On applique ensuite un deuxième pulse de champ magnétique généré par un deuxième pulse de courant dans le conducteur 13 opposé au premier pulse, toujours sans chauffer, de façon à orienter la direction d'aimantation de la couche de référence 3 dans le sens opposé au premier sens prédéterminé. On mesure alors à nouveau la résistance du dispositif magnétique. Après chaque pulse de courant, on connaît la direction d'aimantation de la couche de référence 3, puisqu'on connaît la direction des pulses de champs magnétiques appliqués. Par conséquent, en comparant la résistance du dispositif magnétique après le premier pulse de courant et après le deuxième pulse de courant, on en déduit la direction d'aimantation de la couche de stockage 5, et donc l'information contenue dans la couche de stockage 5.

La figure 6 représente un autre mode de réalisation de l'invention dans lequel la direction d'aimantation de la couche de référence 3 est piégée par une deuxième couche antiferromagnétique 2. La couche de référence 3 est dans cet exemple constituée par un empilement tricouche antiferromagnétique synthétique qui comporte deux couches magnétiques 15 et 16 couplée antiparallèlement à travers une couche conductrice non magnétique 17 par exemple en ruthénium d'épaisseur comprise entre 0.5 nm et 0.9 nm. La première couche magnétique 15 en contact avec la deuxième couche antiferromagnétique est par exemple constituée d'un alliage cobalt-fer, tandis que la deuxième couche magnétique 16 en contact avec l'espaceur 4 est par exemple constituée d'un alliage cobalt-fer-bore.

La couche de stockage 5 dans ce mode de réalisation est également une multicouche. Plus précisément, la couche de stockage 5 comporte :
- une couche de transition 18 constituée d'un matériau ferromagnétique présentant une structure cristallographie cubique face centrée ; la couche de transition 18 est au contact de la première couche antiferromagnétique 6 ; la couche de transition 18 est par exemple en alliage nickel-fer, cobalt-fer ou nickel-fer-cobalt ; la couche de transition 18 peut par exemple être réalisée en alliage Ni₈₀Fe₂₀, ou Co₉₀Fe₁₀ ;
- une couche amorphe ou quasi-amorphe 19 au contact de la couche de transition 18; cette couche amorphe ou quasi-amorphe 19 peut par exemple être réalisée en tantale (Ta), en cuivre (Cu), en ruthénium (Ru), en silice (SiO₂), en oxyde de tantale (TaO), en oxydes d'aluminium (AlOₓ), en oxydes de zirconium (ZrOₓ), en oxydes de titane (TiOₓ), en oxydes de hafnium (HfOₓ), en nitrure de tantale (TaN), en nitrure de titane (TiN), en métaux de transition Co, Fe ou Ni avec ajout de bore, de zirconium, de niobium ou d'hafnium dans des proportions totales d'éléments ajoutés de 5 à 30% atomique ou un alliage de ces composés ;
- une couche ferromagnétique de structure cubique centrée, qui peut par exemple être réalisée en alliage cobalt-fer-bore ou CoFe contenant au moins 30% de Fe.

La couche de stockage formée par ces trois couches 18, 19, 20 présente de préférence une épaisseur totale comprise entre 1.5 et 5 nm.

Les couches de transition 18 et amorphe ou quasi-amorphe 19 permettent de réaliser une transition structurelle entre la première couche antiferromagnétique 6 qui présente une structure cristallographique cubique face centrée et la couche ferromagnétique 20 qui présente une structure cristallographique cubique centrée dans le cas fréquemment rencontré où l'espaceur est une barrière tunnel à base de MgO de symétrie cubique centrée.

Pour écrire une information dans la couche de stockage, on peut soit utiliser la couche de stabilisation comme décrit en référence à la figure 5, ou utiliser la couche de référence comme dans les modes de réalisation dans l'art antérieur. En effet, dans ce mode de réalisation, la direction d'aimantation de la couche de référence est piégée et par conséquent, elle peut être utilisée pour écrire une information dans la couche de stockage. Pour cela, on peut par exemple appliquer un champ magnétique extérieur au dispositif magnétique comme cela a été décrit en relation avec la figure 5. Mais il est aussi possible d'écrire en faisant circuler un courant d'électrons à travers les couches du dispositif magnétique, perpendiculairement aux couches, dans un sens ou l'autre c'est-à-dire de bas en haut ou de haut en bas suivant que l'on veut rendre l'aimantation de la couche de stockage parallèle ou antiparallèle à celle de la couche de référence. Ce courant a un double effet. Tout d'abord, indépendamment de son sens de direction, il provoque par effet Joule au niveau de la barrière tunnel 4 un échauffement de la structure au dessus de la température de Néel de la couche antiferromagnétique 2. Cela a pour effet de libérer l'aimantation de la couche de stockage qui n'est plus piégée par interaction avec la couche antiferromagnétique 2. Par ailleurs, lorsque ce courant d'électrons traverse la couche de référence qui est magnétique, les spins des électrons vont se trouver polarisés en spin, de sorte que les électrons sortiront de cette couche de référence avec un spin polarisé. Lorsque ces électrons traversent la couche de stockage, ils vont subir des interactions d'échange avec les spins responsables de l'aimantation de la couche de stockage. Si la densité de courant est suffisamment forte, ceci va provoquer une réorientation de l'aimantation de cette couche et un alignement de l'aimantation de la couche de stockage par transfert du moment angulaire des électrons polarisés au moment magnétique de la couche de stockage. Ce phénomène est connu sous le nom de transfert de spin. Ainsi, si le courant d'électrons circule de la couche de référence vers la couche de stockage, le transfert de spin va favoriser l'orientation parallèle des aimantations des couches de stockage et de référence. Par contre, si le courant d'électrons circule de la couche de stockage vers la couche de référence, c'est l'alignement antiparallèle qui est favorisé. Dans ce mode d'écriture, le transfert de spin s'exerce avant tout sur l'aimantation de la couche de stockage. Ensuite l'aimantation de la couche de stabilisation se réoriente antiparallèlement à l'aimantation de la couche de stockage du fait de l'interaction magnétostatique entre ces deux couches. Dans ce mode d'écriture, la couche de stabilisation joue toujours le rôle de stabilisation de la couche antiferromagnétique 2 en induisant un couplage effectif inter-grains au sein de cette couche. Toutefois l'effet de levier exercé par l'aimantation de cette couche pour faire commuter l'aimantation de la couche de stockage lors d'une écriture par champ, n'est plus opérant lors de l'écriture par transfert de spin.

En mode lecture, on envoie un courant d'électrons à travers les couches et on mesure la résistance du dispositif magnétique. Ce courant de lecture est d'intensité plus faible que le courant d'écriture (typiquement d'au moins 50%) pour ne pas risquer de perturber par transfert de spin l'orientation magnétique de la couche de stockage au moment de la lecture. On compare ensuite la résistance mesurée à une valeur de référence standard. Si la résistance mesurée est supérieure à cette valeur de référence standard, on en déduit la couche de stockage présente une direction d'aimantation antiparallèle à celle de la couche de référence. Si la résistance mesurée est inférieure à cette valeur de référence standard, on en déduite que les couches de stockage et de référence présentent des directions d'aimantations parallèles.

La figure 7 représente un dispositif magnétique selon un autre mode de réalisation dans lequel la couche de stockage 5 est constituée d'un empilement tricouche antiferromagnétique synthétique qui comporte une première et une deuxième couches magnétiques 23 et 21 séparées par une couche conductrice non magnétique 22 apte à induire un couplage antiparallèle entre les aimantations des couches adjacentes. Avantageusement, la première couche magnétique 23, qui est en contact avec l'espaceur 4, présente un moment magnétique supérieure au moment magnétique de la deuxième couche magnétique 21, qui est en contact avec la première couche antiferromagnétique, de façon à ce que le champ magnétique de fuite, qui est rayonné par la couche de stabilisation, oriente l'aimantation de la première couche magnétique 23 qui est en contact avec l'espaceur 4.

Ce mode de réalisation permet d'avoir moins de distorsion d'aimantation vers les bords du dispositif magnétique grâce à un phénomène de fermeture partielle de flux magnétique entre les couches 21 et 23. En outre, lorsque la première couche antiferromagnétique 6 comporte du manganèse, la couche conductrice non magnétique 22 par exemple en ruthénium permet d'éviter la diffusion du manganèse provenant de la couche antiferromagnétique 2 à travers le dispositif magnétique.

Naturellement, l'invention n'est pas limitée aux modes de réalisation décrits en référence aux figures et des variantes peuvent être envisagées sans sortir du cadre de l'invention. En particulier, les matériaux et les épaisseurs choisis pour réaliser les couches tampon, les couches de référence, les couches de stockage et les espaceurs ne sont donnés ici qu'à titre illustratif et d'autres matériaux ou épaisseurs pourraient être utilisés.

## Revendications

1. Dispositif magnétique à écriture assistée thermiquement comportant :
- une première couche magnétique dite « couche de référence » (3) ;
- une deuxième couche magnétique dite « couche de stockage » (5) qui présente une direction d'aimantation variable ;
- un espaceur (4) situé entre la couche de référence (3) et la couche de stockage (5) ;
- une première couche antiferromagnétique de piégeage (6) au contact de la couche de stockage (5), la première couche antiferromagnétique (6) étant apte à piéger la direction d'aimantation de la couche de stockage (5);
- des moyens de chauffage (12) de ladite couche de piégeage (6) de sorte que, lors du chauffage, la température de ladite couche de piégeage (6) dépasse sa température de blocage de sorte que la direction d'aimantation de ladite couche de stockage (5) ne soit plus piégée ;
- une couche de stabilisation (7) réalisée dans un matériau ferromagnétique, la couche de stabilisation (7) étant au contact de la première couche antiferromagnétique (6) par sa face opposée à la couche de stockage (5).

2. Dispositif magnétique selon la revendication précédente, **caractérisé en ce que** la couche de stabilisation (7) présente un moment magnétique supérieur au moment magnétique de la couche de stockage (5).

3. Dispositif magnétique selon l'une quelconque des revendications précédentes, **caractérisé en ce qu'**il présente une anisotropie de forme dans son plan.

4. Dispositif magnétique selon l'une quelconque des revendications précédentes, dans lequel la couche de stabilisation (7) présente une direction d'aimantation variable, le dispositif magnétique comportant en outre des moyens d'émission d'un champ magnétique aptes à modifier la direction d'aimantation de la couche de stabilisation (7).

5. Dispositif magnétique selon l'une quelconque des revendications précédentes, **caractérisé en ce que** la couche de référence (3) présente une direction d'aimantation piégée par une deuxième couche antiferromagnétique (2) disposée au contact de la couche de référence (3).

6. Dispositif magnétique selon l'une quelconque des revendications 1 à 4, **caractérisé en ce que** la couche de référence (3) présente une direction d'aimantation variable.

7. Dispositif magnétique selon l'une quelconque des revendications précédentes, **caractérisé en ce que** la couche de stockage (5) comporte au moins un empilement formé par:
- une couche de transition (18) constituée d'un matériau ferromagnétique présentant une structure cristallographie cubique face centrée au contact de la première couche antiferromagnétique ;
- une couche amorphe ou quasi-amorphe (19) au contact de la couche de transition ;
- une couche ferromagnétique de stockage (20).

8. Dispositif magnétique selon l'une quelconque des revendications 1 à 6, **caractérisé en ce que** la couche de stockage (5) est constituée d'un empilement tricouche antiferromagnétique synthétique comportant une première (23) et une deuxième couches magnétiques (21) séparées par une couche conductrice non magnétique (22).

9. Dispositif magnétique selon la revendication précédente, **caractérisé en ce que** l'empilement tricouche antiferromagnétique synthétique présente un moment magnétique résultant non nul.

10. Dispositif magnétique selon la revendication précédente, **caractérisé en ce que** la première couche magnétique (23) de l'empilement tricouche antiferromagnétique synthétique est au contact de l'espaceur (4), la deuxième couche magnétique (21) de l'empilement antiferromagnétique synthétique étant au contact de la première couche antiferromagnétique (6), la première couche magnétique (23) de l'empilement tricouche antiferromagnétique synthétique présentant un moment magnétique supérieur au moment magnétique de la deuxième couche magnétique (21) de l'empilement tricouche antiferromagnétique synthétique.

11. Dispositif magnétique selon l'une quelconque des revendications précédentes, **caractérisé en ce que** la couche de référence (3) est constituée d'un empilement tricouche antiferromagnétique synthétique comportant deux couches magnétiques (15, 16) séparées par une couche conductrice non magnétique (17).

12. Mémoire magnétique à écriture assistée thermiquement dont chaque point mémoire est constitué d'un dispositif magnétique selon l'une quelconque des revendications précédentes.

## Patentansprüche

1. Magnetische Vorrichtung mit thermisch unterstütztem Schreiben, umfassend:
- eine erste magnetische Schicht, bezeichnet als "Referenzschicht" (3);
- eine zweite magnetische Schicht, bezeichnet als "Lagerschicht" (5), die eine variable Magnetisierungsrichtung aufweist;
- einen Abstandshalter (4), der sich zwischen der Referenzschicht (3) und der Lagerschicht (5) befindet;
- eine erste antiferromagnetische Einfangschicht (6) mit Kontakt an der Lagerschicht (5), wobei die erste antiferromagnetische Schicht (6) geeignet ist, die Magnetisierungsrichtung der Lagerschicht (5) einzufangen;
- Heizmittel (12) der genannten Einfangschicht (6) derart, dass beim Erhitzen die Temperatur der genannten Einfangschicht (6) ihre Blockiertemperatur derart übersteigt, dass die Magnetisierungsrichtung der genannten Lagerschicht (5) nicht mehr eingefangen ist;
- eine Stabilisierungsschicht (7), die in einem ferromagnetischen Material realisiert ist, wobei die Stabilisierungsschicht (7) mit der ersten antiferromagnetischen Schicht (6) durch ihre der Lagerschicht (5) entgegengesetzte Seite in Kontakt ist.

2. Magnetische Vorrichtung gemäß dem voranstehenden Anspruch, **dadurch gekennzeichnet, dass** die Stabilisierungsschicht (7) ein höheres magnetisches Moment als das magnetische Moment der Lagerschicht (5) aufweist.

3. Magnetische Vorrichtung gemäß einem der voranstehenden Ansprüche, **dadurch gekennzeichnet, dass** sie in ihrer Ebene eine Formanisotropie aufweist.

4. Magnetische Vorrichtung gemäß einem der voranstehenden Ansprüche, bei der die Stabilisierungsschicht (7) eine variable Magnetisierungsrichtung aufweist, wobei die magnetische Vorrichtung darüber hinaus Ausgabemittel eines magnetischen Feldes umfasst, die geeignet sind, die Magnetisierungsrichtung der Stabilisierungsschicht (7) zu verändern.

5. Magnetische Vorrichtung gemäß einem der voranstehenden Ansprüche, **dadurch gekennzeichnet, dass** die Referenzschicht (3) eine Magnetisierungsrichtung aufweist, die durch eine zweite antiferromagnetische Schicht (2) eingefangen ist, welche am Kontakt mit der Referenzschicht (3) angeordnet ist.

6. Magnetische Vorrichtung gemäß Anspruch 1 bis 4, **dadurch gekennzeichnet, dass** die Referenzschicht (3) eine variable Magnetisierungsrichtung aufweist.

7. Magnetische Vorrichtung gemäß einem der voranstehenden Ansprüche, **dadurch gekennzeichnet, dass** die Lagerschicht (5) wenigstens eine Stapelung aufweist, die gebildet ist durch:
- eine Übergangsschicht (18), die aus einem ferromagnetischen Material gebildet ist, welche eine kubische Kristallographiestruktur mit zum Kontakt der ersten antiferromagnetischen Schicht zentrierten Seite aufweist;
- eine amorphe oder quasi-amorphe Schicht (19) am Kontakt mit der Übergangsschicht;
- eine ferromagnetische Lagerschicht (20).

8. Magnetische Vorrichtung gemäß Anspruch 1 bis 6, **dadurch gekennzeichnet, dass** die Lagerschicht (5) aus einer dreischichtigen, antiferromagnetischen, synthetischen Stapelung gebildet ist, umfassend eine erste (23) und eine zweite (21) magnetische Schicht, die durch eine leitende, nicht magnetische Schicht (22) getrennt sind.

9. Magnetische Vorrichtung gemäß dem voranstehenden Anspruch, **dadurch gekennzeichnet, dass** die dreischichtige, antiferromagnetische, synthetische Schicht ein daraus resultierendes magnetisches Moment ungleich Null aufweist.

10. Magnetische Vorrichtung gemäß dem voranstehenden Anspruch, **dadurch gekennzeichnet, dass** die erste magnetische Schicht (23) der dreischichtigen, antiferromagnetischen, synthetischen Stapelung mit dem Abstandshalter (4) in Kontakt ist, wobei die zweite magnetische Schicht (21) der antiferromagnetischen, synthetischen Stapelung mit der ersten antiferromagnetischen Schicht (6) in Kontakt ist, wobei die erste magnetische Schicht (23) der dreischichtigen, antiferromagnetischen, synthetischen Stapelung ein höheres magnetisches Moment aufweist als das magnetische Moment der zweiten magnetischen Schicht (21) der dreischichtigen, antiferromagnetischen, synthetischen Stapelung.

11. Magnetische Vorrichtung gemäß einem der voranstehenden Ansprüche, **dadurch gekennzeichnet, dass** die Referenzschicht (3) aus einer dreischichtigen, antiferromagnetischen, synthetischen Stapelung gebildet ist, umfassend zwei magnetische Schichten (15, 16), die durch eine leitende, nicht magnetische Schicht (17) getrennt sind.

12. Magnetspeicher mit thermisch unterstütztem Schreiben, bei dem jeder Speicherpunkt aus einer magnetischen Vorrichtung gemäß einem der voranstehenden Ansprüche gebildet ist.

## Claims

1. A thermally assisted- writing magnetic device including:
- a first magnetic layer known as "reference layer" (3);
- a second magnetic layer known as "storage layer" (5) which has a variable magnetization direction;
- a spacer (4) located between the reference layer (3) and the storage layer (5);
- a first antiferromagnetic pinning layer (6) in contact with the storage layer (5), the first antiferromagnetic layer (6) being able to pin the magnetization direction of the storage layer (5);
- heating means (12) of said pinning layer (6) so that, upon heating, the temperature of said pinning layer (6) exceeds its blocking temperature so that the magnetization direction of said storage layer (5) is no longer pinned;
- a stabilization layer (7) made of a ferromagnetic material, the stabilization layer (7) being in contact with the first antiferromagnetic layer (6) by its side opposite the storage layer (5).

2. The magnetic device according to the preceding claim, **characterised in that** the stabilization layer (7) has a magnetic moment greater than the magnetic moment of the storage layer (5).

3. The magnetic device according to any of the preceding claims, **characterised in that** it has a shape anisotropy in its plane.

4. The magnetic device according to any of the preceding claims, wherein the stabilization layer (7) has a variable magnetization direction, the magnetic device further including means for emitting a magnetic field able to modify the magnetization direction of the stabilization layer (7).

5. The magnetic device according to any of the preceding claims, **characterised in that** the reference layer (3) has a magnetization direction pinned by a second antiferromagnetic layer (2) disposed in contact with the reference layer (3).

6. The magnetic device according to any of claims 1 to 4, **characterised in that** the reference layer (3) has a variable magnetization direction.

7. The magnetic device according to any of the preceding claims, **characterised in that** the storage layer (5) includes at least one stacking formed by:
- a transition layer (18) made of a ferromagnetic material having a face-centred cubic crystallography structure in contact with the first antiferromagnetic layer;
- an amorphous or nearly amorphous layer (19) in contact with the transition layer;
- a ferromagnetic storage layer (20).

8. The magnetic device according to any of claims 1 to 6, **characterised in that** the storage layer (5) is made of a three-layer synthetic antiferromagnetic stacking including first (23) and second (21) magnetic layers separated by a non-magnetic conducting layer (22).

9. The magnetic device according to the preceding claim, **characterised in that** the three-layer synthetic antiferromagnetic stacking has a resulting non-zero magnetic moment.

10. The magnetic device according to the preceding claim, **characterised in that** the first magnetic layer (23) of the three-layer synthetic antiferromagnetic stacking is in contact with the spacer (4), the second magnetic layer (21) of the synthetic antiferromagnetic stacking being in contact with the first antiferromagnetic layer (6), the first magnetic layer (23) of the three-layer synthetic antiferromagnetic stacking having a magnetic moment greater than the magnetic moment of the second magnetic layer (21) of the three-layer synthetic antiferromagnetic stacking.

11. The magnetic device according to any of the preceding claims, **characterised in that** the reference layer (3) is made of a three-layer synthetic antiferromagnetic stacking including two magnetic layers (15, 16) separated by a non-magnetic conducting layer (17).

12. A thermally assisted-writing magnetic storage, each memory dot of which is made of a magnetic device according to any of the preceding claims.
